# EUROPEAN PATENT APPLICATION

(11) **EP 3 588 536 A1**
(43) Date of publication of application: **01.01.2020**
(21) Application number: 18756763.1
(22) Date of filing: 06.02.2018
(51) Int. Cl.: H01L 21/304, B24B 37/00, C09K 3/14

(54) **METHOD FOR POLISHING SILICON CARBIDE SUBSTRATE**

(30) Priority: 21.02.2017 JP 2017030216
(71) Applicant: Fujimi Incorporated, Kiyosu-shi, Aichi 452-8502 (JP)
(72) Inventor: TOUJINBARA, Kazuma, Kiyosu-shi Aichi 452-8502 (JP); MIWA, Naoya, Kiyosu-shi Aichi 452-8502 (JP); ASHITAKA, Keiji, Kiyosu-shi Aichi 452-8502 (JP)
(74) Representative: Grünecker Patent- und Rechtsanwälte PartG mbB
(86) International application number: PCT/JP2018/004016
(87) International publication number: WO 2018/155168

(57) **Abstract**

The present invention addresses the problem of providing a polishing method for polishing a silicon carbide substrate, which is capable of increasing the polishing speed even when using a polishing pad that usually does not lead to an increase in polishing speed.

A polishing method for polishing a silicon carbide substrate, the polishing method including a primary polishing step of polishing with a polishing member A containing abrasive grains using a polishing pad, the primary polishing step being polishing performed in association with a solid-phase reaction between the abrasive grains and the silicon carbide substrate.

## Description

### TECHNICAL FIELD

The present invention relates to a polishing method for polishing a silicon carbide substrate.

### Prior Art

In the field of power semiconductors, the utilization of silicon carbide (SiC) power devices having improved high-temperature operability as compared with silicon (Si), together with reduced size and increased energy saving effects, is expected. In addition, with the production of larger-diameter substrates and the progress of mass production, the importance of substrate processing technology has been increasing. However, silicon carbide has extremely high hardness and is thermally/chemically stable, and thus its processing is extremely difficult.

Incidentally, basically as with Si substrates, the processing process for SiC substrates includes cutting an ingot, lapping and/or grinding for uniformizing the thickness or shape of cut wafers (so-called "rough lapping step"), finish polishing for removing damaged layers (so-called "finishing step"), and the like.

However, as compared with Si, SiC is much harder and chemical/thermally more stable. Therefore, abrasive grains which are generally used for the lapping of a Si substrate, such as green silicon carbide (GC) abrasive grains and FO abrasive grains (mixture of brown alumina and zircon), cannot be used.

Thus, for a polishing of a silicon carbide substrate, how to efficiently polish such a hard-to-polish silicon carbide substrate is an important issue.

In order to solve such problems, a polishing technology using high-hardness diamond abrasive grains and a platen is known (Patent Literature 1).

### Citation List

### Patent Literatures

Patent Literature 1: JP 2009-172737 A

### SUMMARY OF INVENTION

### Problem to be solved by the Invention

However, the present inventors have found that the productivity does not increase with prior art, and, from the overall standpoint, the silicon carbide substrate polishing efficiency may not increase. In the course of extensive research about the causes thereof, the present inventors have taken particular note of a platen for polishing. In the case of using a platen, leveling (start-up operation), facing, and the like unexpectedly take time and effort, and they have considered this is a one cause that the silicon carbide substrate polishing efficiency does not increase.

Meanwhile, as described above, SiC is much harder and chemical/thermally more stable as compared with Si. In other words, unless polishing is performed using a hard member such as a platen which is not like a polishing pad, the SiC polishing speed does not usually increase. Like this, it has been found that a polishing method for polishing a silicon carbide substrate has contradicting problems.

Therefore, the present invention addresses the problem of providing a polishing method for polishing a silicon carbide substrate, which is capable of increasing the polishing speed even when using a polishing pad that usually does not lead to an increase in polishing speed.

### Means for Solving the Problem

The above problem is solved by a polishing method for polishing a silicon carbide substrate, the polishing method including a primary polishing step of polishing with a polishing member A containing abrasive grains using a polishing pad, the primary polishing step being a polishing performed in association with a solid-phase reaction between the abrasive grains and the silicon carbide substrate.

### Effects of the Invention

According to the present invention, a polishing method for polishing a silicon carbide substrate, which is capable of increasing the polishing speed even when using a polishing pad that usually does not lead to an increase in polishing speed, can be provided.

### BRIEF DESCRIPTION OF DRAWINGS

Fig. 1 shows the XRD measurement results of SiC alone.
Fig. 2 shows the XRD measurement results of TiB₂ alone.
Fig. 3 shows the XRD measurement results of a mixture of TiB₂ and SiC.
Fig. 4 shows the XRD measurement results of B₄C alone.
Fig. 5 shows the XRD measurement results of a mixture of B₄C and SiC.
Fig. 6 shows the XRD measurement results of MgO alone.
Fig. 7 shows the XRD measurement results of a mixture of MgO and SiC.

### DESCRIPTION OF EMBODIMENTS

Hereinafter, the present invention will be described. Incidentally, the present invention is not limited only to the following embodiments. In addition, unless otherwise noted, the operations and the measurement of physical properties and the like are performed under conditions of room temperature (20°C or more and 25°C or less)/a relative humidity of 40%RH or more and 50%RH or less.

The present invention is a polishing method for polishing a silicon carbide substrate. The polishing method includes a primary polishing step of polishing with a polishing member A containing abrasive grains using a polishing pad. The primary polishing step is a polishing performed in association with a solid-phase reaction between the abrasive grains and the silicon carbide substrate. According to this configuration, a polishing method for polishing a silicon carbide substrate, which is capable of increasing the polishing speed even when using a polishing pad that usually does not lead to an increase in polishing speed, can be provided.

Hereinafter, the configuration of the polishing method of the present invention will be described in detail.

### <Object to Be Polished>

First, the object to be polished that is polished by the polishing method of the present invention will be described. The object to be polished that is polished by the polishing method of the present invention is silicon carbide.

Generally, the processing method for a silicon carbide substrate includes cutting an ingot, lapping and/or grinding for uniformizing the thickness or shape of cut wafers (so-called "rough lapping step"), finish polishing for removing damaged layers (so-called "finishing step"), and the like. That is, after cutting the ingot, plane cutting is performed using fixed abrasive grains, and/or, using a metal platen, a high-hardness material such as diamond is used as abrasive grains, whereby a silicon carbide substrate having desired surface roughness or flatness is obtained (so-called "rough lapping step (including a diamond lapping step)"). Finally, in order to eliminate surface cracks and the like caused by the "diamond lapping step", a finish polishing step is performed using CMP or the like (so-called "finish polishing step").

Meanwhile, in the polishing method of the present invention, as an alternative for the diamond lapping step (primary polishing step), a silicon carbide substrate is polished using a polishing pad, and the polishing is performed in association with a solid-phase reaction between abrasive grains and the silicon carbide substrate.

### <Primary Polishing Step>

The polishing method of the present invention includes a primary polishing step of polishing with a polishing member A containing abrasive grains using a polishing pad, and the primary polishing step is a polishing performed in association with a solid-phase reaction between the abrasive grains and the silicon carbide substrate.

### [Polishing Pad]

The polishing pad used in the primary polishing step of the present invention is not particularly limited, and may be a hard foaming type, a nonwoven fabric type, a suede type, or the like. Among them, in terms of hardness, a hard foaming type is preferable, and a polyurethane pad is particularly preferable.

In terms of enhancing a polishing performance, the Shore D hardness of the polishing pad is preferably 50 or more, more preferably 55 or more, and still more preferably 60 or more. Incidentally, although the upper limit of the hardness is not particularly set, only as a guide, it is preferable that the hardness is lower than that of the platen. The Shore D hardness can be measured using the method of JIS Z2246:2000, and is measured in such the manner in the Examples. When a polishing pad having relatively high hardness is selected for use in the primary polishing step of the present invention, the exertion of the mechanical action is improved, and the polishing performance can be improved.

In addition, the polishing method of the present invention is also characterized in that the conventional diamond lapping step using a metal platen is not employed, and a primary polishing step is performed using a polishing pad. According to common knowledge in the art, when such a polishing pad (having hardness lower than the hardness of the metal platen) is used, usually, the polishing performance on the silicon carbide substrate, which is a substance having extremely high hardness, significantly decreases, and the production efficiency decreases. However, in the present invention, even when such a polishing pad is used, a high polishing performance can be secured; this is another characteristic.

### [Polishing Member A Containing Abrasive Grains]

In order to improve the silicon carbide substrate polishing performance, presumably, it is preferable to select abrasive grains having relatively high hardness in expectation of the mechanical action.

However, the present inventors have found that even when high-hardness abrasive grains are used, the polishing performance does not improve as much as expected. Then, the present inventors have conducted intensive research, and, as a result, found that when a primary polishing step is performed in association with a solid-phase reaction between abrasive grains and a silicon carbide substrate, the polishing performance improves to a surprising extent.

Such abrasive grains are not limited as long as they cause a solid-phase reaction with a silicon carbide substrate at the time of polishing. However, according to a preferred embodiment of the present invention, the abrasive grains are ones such that a maximum diffraction peak intensity observed at a diffraction angle 2θ in a range of 20 to 40° when a calcined product obtained by heating the abrasive grains alone or silicon carbide alone from 25°C to 1500°C is subjected to X-ray diffraction, has been decreased to equal to or less than a composite peak intensity of the calcined product of the abrasive grains alone and the calcined product of the silicon carbide alone at the diffraction angle 2θ of the maximum diffraction peak intensity when a calcined product obtained by heating a mixture of the silicon carbide and the abrasive grains at a weight ratio of 1:1 from 25°C to 1500°C is subjected to X-ray diffraction. Therefore, a preferred embodiment of the present invention also provides a polishing method, wherein a maximum diffraction peak intensity observed at a diffraction angle 2θ in a range of 20 to 40° when a calcined product obtained by heating the abrasive grains alone or silicon carbide alone from 25°C to 1500°C is subjected to X-ray diffraction, has been decreased to equal to or less than a composite peak intensity of the calcined product of the abrasive grains alone and the calcined product of the silicon carbide alone at the diffraction angle 2θ of the maximum diffraction peak intensity when a calcined product obtained by heating a mixture of the silicon carbide and the abrasive grains at a weight ratio of 1:1 from 25°C to 1500°C is subjected to X-ray diffraction.

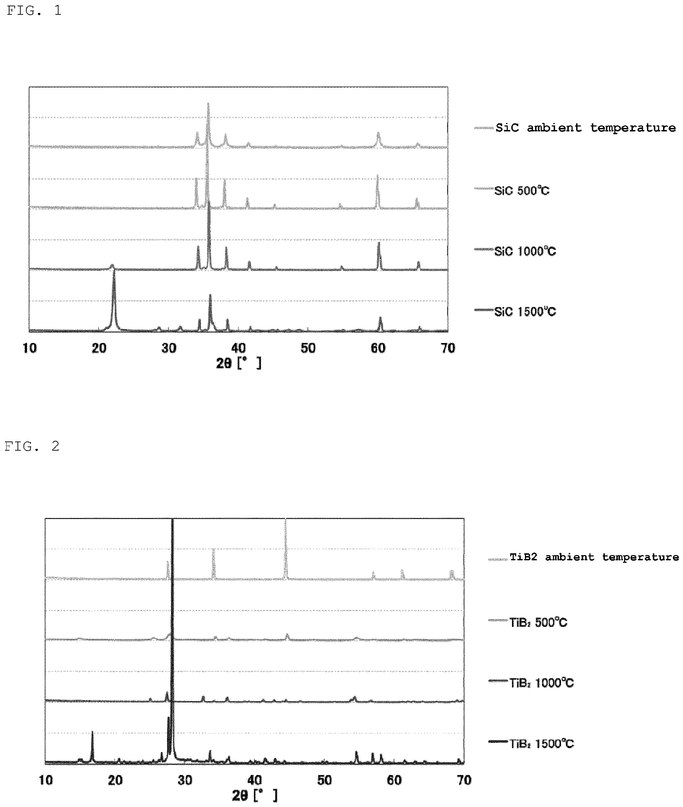

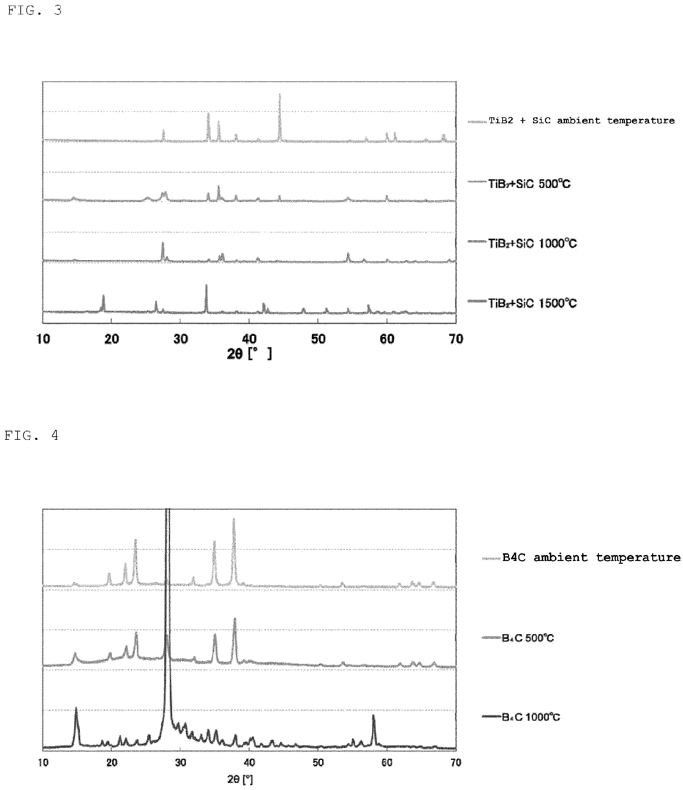

Here, abrasive grains having such characteristics will be described in detail using Fig. 1, Fig. 2, and Fig. 3 of the Examples. Fig. 1 shows the XRD measurement results of silicon carbide alone, which is the material of an object to be polished. Fig. 2 shows the XRD measurement results of TiB₂ alone. Then, Fig. 3 shows the XRD measurement results of a mixture of TiB₂ and silicon carbide. As shown in Fig. 1, when a calcined product obtained by heating silicon carbide (SiC) alone from 25°C (ambient temperature, the same hereinafter) to 1500°C is subjected to XRD measurement, at least at 1500°C, a specific peak appears near a diffraction angle 2θ of 22°. In addition, as shown in Fig. 2, when a calcined product obtained by heating TiB₂ alone from 25°C (ambient temperature, the same hereinafter) to 1500°C is subjected to XRD measurement, at least at 1500°C, a specific peak appears near a diffraction angle 2θ of 28°. Meanwhile, the strong peak near 22°, which had been observed in silicon carbide alone, almost has been disappeared when silicon carbide was mixed with TiB₂ and calcined, as shown by Fig. 3. Similarly, the strong peak near 28°, which had been observed in TiB₂ alone, almost has been disappeared when TiB₂ was mixed with silicon carbide and calcined, as shown by Fig. 3.

Here, it is assumed that if no reaction has occurred between TiB₂ and silicon carbide, the peak of a calcined product of a mixture of TiB₂ and silicon carbide will be like a simple composite of the peak of a calcined product of silicon carbide alone and the peak of a calcined product of TiB₂ alone. However, as shown in Fig. 3, it can be seen that with respect to both the peak intensity of the calcined product of TiB₂ alone and the peak intensity of the calcined product of silicon carbide alone, when the two are mixed and calcined, the peak intensity is lower than assumed. In other words, it can be interpreted that as a result of heating TiB₂ and silicon carbide to 1500°C, a reaction (solid-phase reaction) has occurred. Hereinafter, the concept of "decrease to equal to or less than a composite peak intensity" will be understood in the same manner.

In addition, according to another preferred embodiment of the present invention, such abrasive grains are abrasive grains for use in a primary polishing step of polishing using a polishing pad in a polishing method for polishing a silicon carbide substrate. The abrasive grains were ones such that a maximum diffraction peak intensity observed at a diffraction angle 2θ in a range of 20 to 40° when a calcined product obtained by heating the abrasive grains alone silicon carbide alone from 25°C to 1000°C is subjected to X-ray diffraction, has been decreased to equal to or less than a composite peak intensity of the calcined product of the abrasive grains alone and the calcined product of the silicon carbide alone at the diffraction angle 2θ of the maximum diffraction peak intensity when a calcined product obtained by heating a mixture of the silicon carbide and the abrasive grains at a weight ratio of 1:1 from 25°C to 1000°C is subjected to X-ray diffraction. In addition, a polishing member containing the abrasive grains is also provided.

In addition, a preferred embodiment of the present invention provides a polishing method, wherein a maximum diffraction peak intensity observed at a diffraction angle 2θ in a range of 20 to 40° when a calcined product obtained by heating the abrasive grains or silicon carbide alone from 25°C to 1000°C is subjected to X-ray diffraction, has been decreased to equal to or less than a composite peak intensity of the calcined product of the abrasive grains alone and the calcined product of the silicon carbide alone at the diffraction angle 2θ of the maximum diffraction peak intensity when a calcined product obtained by heating a mixture of the silicon carbide and the abrasive grains at a weight ratio of 1:1 from 25°C to 1000°C is subjected to X-ray diffraction.

Like this, when the diffraction peak observed in a calcined product of each alone shows a decrease in a calcined product of a mixture, it can be judged that a solid-phase reaction has occurred. Incidentally, at the time of X-ray diffraction, silicon carbide and abrasive grains are both in power form, and, in terms of handling and measurement accuracy, it is preferable that the average secondary particle size of each powder is 0.1 to 10 µm.

The reason why the polishing performance improves when a silicon carbide substrate is polished using the abrasive grains having such characteristics is presumed to be as follows. That is, in the primary polishing step, while supplying a polishing member A containing abrasive grains, the silicon carbide substrate is polished while rotating a platen having attached thereto a polishing pad. As a result of this rotation, frictional heat is generated between the abrasive grains and the silicon carbide substrate. This frictional heat presumably reaches 1000°C or more (1500°C or more in some cases), that is, presumably, the same phenomenon as in the case of obtaining the mixture calcined product occurs. Accordingly, presumably, the abrasive grains having such characteristics cause a solid-phase reaction with the silicon carbide substrate at the time of polishing, and, due to the action of the solid-phase reaction, the polishing of the silicon carbide substrate is accelerated. Incidentally, the method for producing a calcined product and the conditions for the powder X-ray diffraction peak measurement are in accordance with the methods described in the Examples.

As described above, the present invention also provides abrasive grains for use in a primary polishing step of polishing using a polishing pad in a polishing method for polishing a silicon carbide substrate, the abrasive grains having a function of polishing in association with a solid-phase reaction with the silicon carbide substrate. In addition, a polishing member containing the abrasive grains is also provided.

In addition, the present invention also provides abrasive grains for use in a primary polishing step of polishing using a polishing pad in a polishing method for polishing a silicon carbide substrate, the abrasive grains are ones such that a maximum diffraction peak intensity observed at a diffraction angle 2θ in a range of 20 to 40° when a calcined product obtained by heating the abrasive grains alone or silicon carbide alone from 25°C to 1500°C is subjected to X-ray diffraction, has been decreased to equal to or less than a composite peak intensity of the calcined product of the abrasive grains alone and the calcined product of the silicon carbide alone at the diffraction angle 2θ of the maximum diffraction peak intensity when a calcined product obtained by heating a mixture of the silicon carbide and the abrasive grains at a weight ratio of 1:1 from 25°C to 1500°C is subjected to X-ray diffraction. In addition, a polishing member containing the abrasive grains is also provided.

Specific examples of the abrasive grains typically include B₄C, TiB₂, and MgO. In addition, in a preferred embodiment of the present invention, the abrasive grains are B₄C or TiB₂. According to such an embodiment, a solid-phase reaction can be developed more efficiently.

In a preferred embodiment of the present invention, the lower limit of the Vickers hardness of the abrasive grains is preferably 2,000 Hv or more, more preferably 2,100 Hv or more, and still more preferably 2,200 Hv or more. Meanwhile, the upper limit of the Vickers hardness is preferably 4,000 Hv or less, more preferably 3,500 Hv or less, still more preferably 3,000 Hv or less, still more preferably 2,500 Hv or less, and yet more preferably 2,350 Hv or less. Therefore, in a preferred embodiment of the present invention, the Vickers hardness of abrasive grains is 2,000 Hv or more and 4,000 Hv or less. Within this range, the polishing performance further improves, and damage to the polishing-processed surface can be reduced. Incidentally, the measurement method for Vickers hardness is in accordance with JIS Z2244:2009.

In terms of polishing performance, the lower limit of the average secondary particle size of abrasive grains is preferably 5 µm or more, more preferably 15 µm or more, still more preferably 30 µm or more, yet more preferably 33 µm or more, yet more preferably 35 µm or more, and yet more preferably 36 µm or more. In addition, in terms of reducing damage to the polishing-processed surface, the upper limit of the average secondary particle size of abrasive grains is preferably 50 µm or less, more preferably 45 µm or less, and still more preferably 40 µm or less. Therefore, in a preferred embodiment of the present invention, the average secondary particle size of abrasive grains is 5 to 50 µm. Such a range has the effect that high polishing performance can be achieved while suppressing damage to the polishing-processed surface to an acceptable level or lower. Incidentally, the average secondary particle size of abrasive grains can be measured by a dynamic light scattering method, such as a laser diffraction/scattering method, for example. Also in the Examples of the present invention, calculation is performed in such a manner.

The form of the polishing member A is not particularly limited. However, in a preferred embodiment of the present invention, the polishing member A is a polishing slurry containing abrasive grains. In another embodiment of the present invention, the polishing member A may be the abrasive grains in powder form. In the case where the polishing member A is in the form of a polishing slurry containing abrasive grains, the polishing member A contains a dispersing medium. As a dispersing medium, organic solvents and water are available. Among them, it is preferable to contain water.

In the case where the polishing member A is in the form of a polishing slurry containing abrasive grains, in terms of ensuring contact points between abrasive grains and silicon carbide for promoting the solid-phase reaction, the lower limit of the content of abrasive grains in the polishing member A is preferably 1 mass% or more, more preferably 3 mass% or more, still more preferably 5 mass% or more, yet more preferably 10 mass% or more, and yet more preferably 13 mass% or more. In addition, the upper limit of the content of abrasive grains in the polishing member A is preferably 30 mass% or less, more preferably 25 mass% or less, still more preferably 20 mass% or less, and yet more preferably 18 mass% or less. Such a range has the effect that high polishing performance can be achieved while reducing the cost.

### [Method for Producing Polishing Member A]

The method for producing the polishing member A of the present invention is not particularly limited. For example, it can be obtained by stir-mixing abrasive grains together with other components as necessary in a dispersing medium. The order of mixing the components, the temperature at the time of mixing, or the mixing time is not particularly limited either. Incidentally, other components will be described below.

### <Finish Polishing Step>

The polishing method of the present invention may include a finish polishing step after the primary polishing step. In a preferred embodiment, in the finish polishing step, a polishing is performed with a polishing slurry B containing abrasive grains B using a polishing pad. As a polishing pad, known one can be used.

Abrasive grains B contained in the polishing slurry B may be any of inorganic particles, organic particles, and organic-inorganic composite particles. Specific examples of inorganic particles include silica such as colloidal silica, particles of metal oxides such as ceria, titania, and alumina, silicon nitride particles, silicon carbide particles, and boron nitride particles. Specific examples of organic particles include latex particles, polystyrene particles, and polymethyl methacrylate (PMMA) particles. The abrasive grains may be used alone, or it is also possible to use a composite thereof or a mixture of two or more kinds. In addition, the abrasive grains used may be a commercially available product or a synthetic product.

Among these abrasive grains, silica is preferable. Incidentally, in terms of suppressing the generation of polishing scratches, colloidal silica is particularly preferable.

The average primary particle size, average secondary particle size, and particle size distribution of abrasive grains B, the content of abrasive grains B in the polishing slurry B, the pH of the polishing slurry B, and the like can be applied suitably with reference to known conditions. In addition, the dispersing medium used in the polishing slurry B is not particularly limited, and an organic solvent, water, or the like is used.

The method for producing the polishing slurry B of the present invention is not particularly limited. For example, it can be obtained by stir-mixing abrasive grains B together with other components as necessary in a dispersing medium. The order of mixing the components, the temperature at the time of mixing, the mixing time, or the like is not particularly limited either.

### [Other Components]

The polishing member A and the polishing slurry B of the present invention may further contain, as necessary, other components including additives for further enhancing the polishing speed, such as complexing agents, etching agents, and oxidizing agents, additives for imparting hydrophilicity or dispersion effects to the surface of a silicon carbide substrate, antiseptic agents, antifungal agents, antirust agents, chelating agents, dispersants for improving the dispersibility of abrasive grains, dispersion aids for facilitating the re-dispersion of aggregates of abrasive grains, pH adjusting agents, and the like.

However, in the case where an additive for imparting hydrophilicity or dispersion effects to the surface of a silicon carbide substrate, a dispersant, a dispersion aid, or the like is added, the processing of the silicon carbide substrate caused by the solid-phase reaction may be suppressed, whereby a preferred polishing speed is not obtained. Therefore, in the case where these additives are added, the amount thereof added is preferably less than 1 mass%, more preferably less than 0.5 mass%, and still more preferably less than 0.1 mass% relative to the polishing member A. This also applies to the polishing slurry B.

The lower limit of the pH of the polishing member A of the present invention, preferably 6.0 or more, more preferably 6.5 or more, still more preferably 7.0 or more, yet more preferably 7.3 or more, and, yet more preferably 7.5 or more. In addition, the upper limit of the pH of the polishing member A is preferably 9.0 or less, more preferably 8.5 or less, and still more preferably 8.2 or less.

### <Polishing Method>

The polishing method of the present invention is a polishing method for polishing a silicon carbide substrate, the polishing method including a primary polishing step of polishing with a polishing member A containing abrasive grains using a polishing pad, the primary polishing step being polishing performed in association with a solid-phase reaction between the abrasive grains and the silicon carbide substrate. In addition, in the polishing method of the present invention, the primary polishing step may be followed by a finish polishing step of polishing with a polishing slurry B containing abrasive grains B.

The primary polishing step or the finish polishing step on a silicon carbide substrate can be performed using ordinary devices and conditions that are used for the polishing of a silicon carbide substrate. Common polishing devices include single-side polishing devices and double-side polishing devices.

In a single-side polishing device, a silicon carbide substrate is held using a holding jig called a carrier, then, while supplying the polishing member A in the primary polishing step or the polishing slurry B in the finish polishing step, a platen having attached thereto a polishing pad is pressed against one side of the silicon carbide substrate, and the platen is rotated, whereby one side of the silicon carbide substrate is polished.

In a double-side polishing device, a silicon carbide substrate is held using a holding jig called a carrier, then, while supplying the polishing member A in the primary polishing step or the polishing slurry B in the finish polishing step from above, platens having attached thereto a polishing pad are pressed against the opposed surfaces of the silicon carbide substrate, and they are rotated in relative directions, whereby both sides of the silicon carbide substrate are polished.

As a polishing condition in the polishing method of the present invention, the polishing load can be mentioned. Generally, with an increase in load, the frictional force of abrasive grains increases, and the mechanical processing force improves. At the same time, the solid-phase reaction by frictional heat is also promoted. Accordingly, the polishing speed increases.

The load in the polishing method of the present invention is not particularly limited. However, for a sufficient polishing speed, and in order to suppress the formation of defects such as scratches on the surface, the load per unit area of the substrate in the primary polishing step is preferably 150 g/cm² or more, more preferably 200 g/cm² or more, still more preferably 250 g/cm² or more, and yet more preferably 280 g/cm² or more. In addition, the upper limit of the load per unit area of the substrate is preferably 750 g/cm² or less, more preferably 400 g/cm² or less, still more preferably 350 g/cm² or less, and yet more preferably 330 g/cm² or less. Incidentally, the load in the primary polishing step is not limited to the above, and, because the temperature at which a solid-phase reaction is caused varies depending on the kind of abrasive grains, the load may be suitably adjusted to make such a temperature.

In addition, the load in the finish polishing step per unit area of the substrate is preferably 150 g/cm² or more, more preferably 200 g/cm² or more, and still more preferably 250 g/cm² or more. In addition, the upper limit of the load per unit area of the substrate is preferably 750 g/cm² or less, more preferably 400 g/cm² or less, and still more preferably 350 g/cm² or less.

As a polishing condition in the polishing method of the present invention, in the primary polishing step, the lower limit of the rotation speed of the platen in a single-side polishing device is preferably 90 rpm or more, and more preferably 100 rpm or more. In addition, the upper limit of the rotation speed is preferably 130 rpm or less, and more preferably 120 rpm or less. In the primary polishing step, the lower limit of the rotation speed of the platen in a double-side polishing device is preferably 20 rpm or more, and more preferably 30 rpm or more. The upper limit of the rotation speed is preferably 60 rpm or less, and more preferably 50 rpm or less. Incidentally, the rotation speed in the primary polishing step is not limited to the above, and, because the temperature at which a solid-phase reaction is caused varies depending on the kind of abrasive grains, the rotation speed may be suitably adjusted to make such a temperature.

In the finish polishing step, the lower limit of the rotation speed of the platen in a single-side polishing device is not particularly limited, but is preferably 90 rpm or more, and more preferably 100 rpm or more. In addition, the upper limit of the rotation speed is not particularly limited, but is preferably 130 rpm or less, and more preferably 120 rpm or less. In the finish polishing step, the lower limit of the rotation speed of the platen in a double-side polishing device is not particularly limited, but is preferably 20 rpm or more, and more preferably 30 rpm or more. The upper limit of the rotation speed is not particularly limited, but is preferably 60 rpm or less, and more preferably 50 rpm or less.

The supply amounts of the polishing member A and the polishing slurry B depend on the polishing device and polishing conditions, but should be the amounts enough for supplying the polishing member A and the polishing slurry B uniformly over the entire surface between the substrate and the polishing pad.

### <Method for Producing Polished Silicon Carbide Substrate>

The present invention provides a method for producing a polished silicon carbide substrate, including a step of polishing by the polishing method described above or a primary polishing step of polishing a silicon carbide substrate using the abrasive grains described above using a polishing pad. According to this configuration, a polished silicon carbide substrate can be efficiently produced. That is, according to the method, the productivity improves.

### Examples

The present invention will be described in further detail using the following examples and comparative examples. However, the technical scope of the present invention is not limited only to the following examples.

### <Example 1>

### (Primary Polishing Step)

In pure water, abrasive grains (material: B₄C, average secondary particle size: 38 µm, Vickers hardness: 2,250 Hv) were dispersed at 15 mass%, thereby preparing a polishing member A. Incidentally, in the example and comparative examples, the pH was as follows: Example 1: 7.9, Comparative Example 1: 7.9, Comparative Example 2: 8.2, Comparative Example 3: 8.0, and Comparative Example 4: 7.7. The pH of the polishing member A (liquid temperature: 25°C) was checked with a pH meter (manufactured by HORIBA, Ltd., Model No.: LAQUA F-71).

Using the polishing member A, a silicon carbide substrate (19.63 cm²) was polished on one side under the following conditions.

**[Table 1]**

| <Silicon Carbide Substrate Polishing Conditions in a Primary Polishing Step> |
|---|
| Polishing device: manufactured by Engis Japan Corporation |
| Polishing load (processing pressure): 300 g/cm² |
| Polishing pad: polyurethane polishing pad (Shore D hardness: 62) |
| Polishing time: 20 min |
| Flow rate: 10 ml/min |
| Platen rotation speed: 110 rpm |

### <Comparative Example 1>

The polishing performance was examined in the same manner as in Example 1, except that in the primary polishing step of Example 1, the abrasive grains and the platen were changed as shown in Table 1, and the platen rotation speed was changed to 40 rpm.

### <Comparative Example 2>

The polishing performance was examined in the same manner as in Example 1, except that in the primary polishing step of Example 1, the abrasive grains and the platen were changed as shown in Table 1, and the platen rotation speed was changed to 40 rpm.

### <Comparative Example 3>

The polishing performance was examined in the same manner as in Example 1, except that in the primary polishing step of Example 1, the abrasive grains were changed as shown in Table 1.

### <Comparative Example 4>

The polishing performance was examined in the same manner as in Example 1, except that in the primary polishing step of Example 1, the abrasive grains and the platen were changed as shown in Table 1, and the platen rotation speed was changed to 40 rpm.

### <Polishing Performance>

Using the polishing member A of each of Example 1 and the comparative examples, polishing was performed for 20 minutes. The weight of the silicon carbide substrate was measured before and after polishing, and, from the difference in weight before and after polishing, the polishing performance (polishing speed) was calculated. The results are shown in Table 1 below.

### <X-Ray Diffraction Spectrum (XRD)>

SiC alone (average secondary particle size: 4.4 µm) ;
TiB₂ alone (average secondary particle size: 3.4 µm) ;
mixture of TiB₂ (average secondary particle size: 3.4 µm) and SiC (average secondary particle size: 4.4 µm) (weight ratio of 1:1);
B₄C alone (average secondary particle size: 4.6 µm);
mixture of B₄C (average secondary particle size 4.6 µm) and SiC (average secondary particle size: 4.4 µm) (weight ratio of 1:1);
MgO alone (average secondary particle size: 5.2 µm); and
mixture of MgO (average secondary particle size 5.2 µm) and SiC (average secondary particle size: 4.4 µm) (weight ratio of 1:1);
were prepared.

Incidentally, they are all in powder form.

Incidentally, the average secondary particle size was measured using "LA-950-V2" manufactured by HORIBA Co., Ltd., which is a laser diffraction/scattering particle size distribution analyzer.

Subsequently, each powder was calcined from 25°C to 1000°C (or 1500°C) at a temperature rise rate of 2.5°C/min for 4 hours to prepare a sample. Subsequently, XRD of each sample was measured. The measurement conditions are as follows.

### (Measurement Conditions)

X-Ray: 20 kV/10 mA
Divergence slit: 1°
Divergence longitudinal restriction slit: 10 mm
Scattering slit: 2°
Receiving slit: 0.05 mm
Start: 10°
Stop: 70°
Step: 0.01°.

As a result of measurement, it can be seen that the maximum diffraction peak intensity observed at a diffraction angle 2θ in a range of 20 to 40° when calcined product obtained by heating TiB₂ alone from 25°C to 1500°C is subjected to X-ray diffraction, has been decreased when a calcined product obtained by heating a mixture of silicon carbide and TiB₂ at a weight ratio of 1:1 from 25°C to 1500°C is subjected to X-ray diffraction (Figs. 2 and 3).

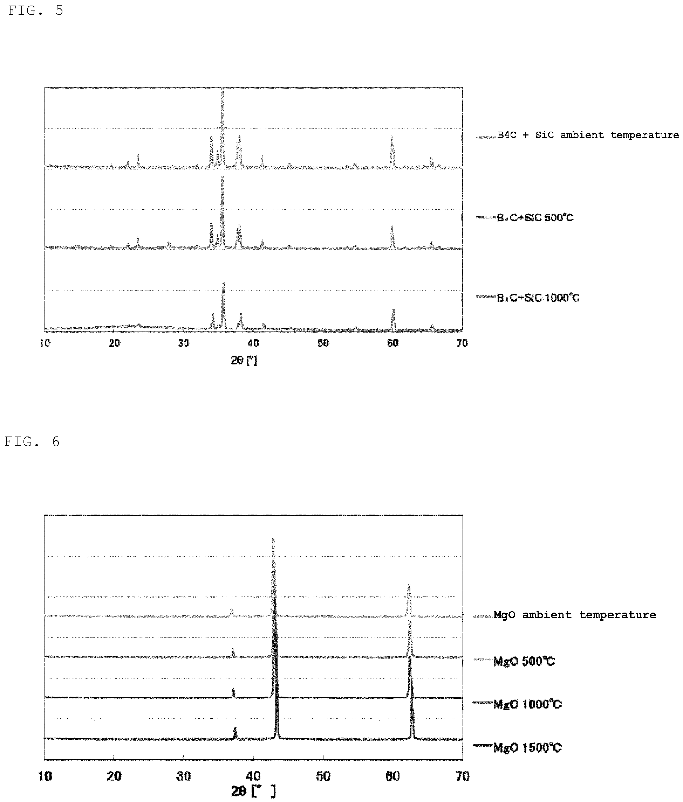

In addition, it can be seen that the maximum diffraction peak intensity observed at a diffraction angle 2θ in a range of 20 to 40° when a calcined product obtained by heating B₄C alone from 25°C to 1000°C is subjected to X-ray diffraction, has been decreased when a calcined product obtained by heating a mixture of silicon carbide and B₄C at a weight ratio of 1:1 from 25°C to 1000°C is subjected to X-ray diffraction (Figs. 4 and 5).

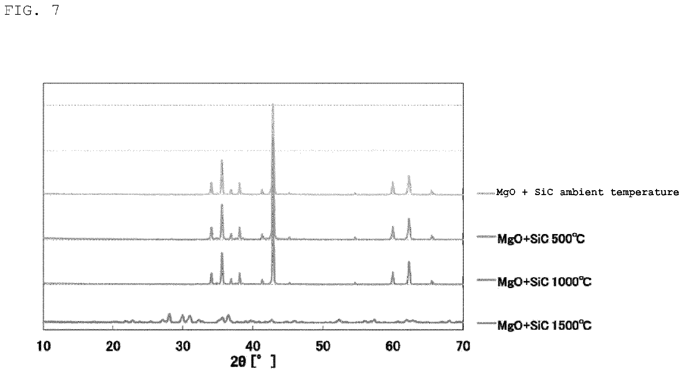

In addition, it can be seen that the maximum diffraction peak intensity observed at a diffraction angle 2θ in a range of 20 to 40° when a calcined product obtained by heating MgO alone from 25°C to 1500°C is subjected to X-ray diffraction, has been decreased when a calcined product obtained by heating a mixture of silicon carbide and MgO at a weight ratio of 1:1 from 25°C to 1500°C is subjected to X-ray diffraction (Figs. 6 and 7). That is, it can be seen that a solid-phase reaction with silicon carbide takes place at least at the time of 1500°C in the cases of TiB₂ and MgO and at least at the time of 1000°C in the case of B₄C (in Table 1, the occurrence of the solid-phase reactivity was rated as "○"). Meanwhile, no solid-phase reaction takes place between SiC and SiC, and also no solid-phase reaction takes place between SiC and diamond, "×" was shown in Table 1.

Incidentally, relative to the top peak intensity near a diffraction angle 2θ of 22° of a calcined product obtained by heating silicon carbide alone to 1500°C, the rate of the intensity decrease in the near a diffraction angle 2θ of 22° of a calcined product obtained by heating each mixture from 25°C to 1500°C was as follows: TiB₂: 96.8%, B₄C: 91.4%, and MgO: 97.6% (Fig. 1, Fig. 3, Fig. 5, and Fig. 7).

### [Table 2]

**Table 1**

| | Abrasive grains | | | Pad/platen | Solid-phase reactivity with silicon carbide XRD | Polishing performance [µm/min] | Leveling (start-up operation) and facing |
|---|---|---|---|---|---|---|---|
| | Material | Particle size (D₅₀) [µm] | Vickers hardness [Hv] | | | | |
| Example 1 | B₄C | 38 | 2,250 | Pad | ○ | 0.6 | Unnecessary |
| Comparative Example 1 | B₄C | 10 | 2,250 | Platen (cast iron) | ○ | 0.5 | Necessary |
| Comparative Example 2 | TiB₂ | 37 | 3,366 | Platen (cast iron) | ○ | 0.2 | Necessary |
| Comparative Example 3 | SiC | 49 | 2,150 | Pad | × | 0.02 | Unnecessary |
| Comparative Example 4 | Diamond | 3 | 5,000 | Platen (cast iron) | × | 0.6 | Necessary |

### <Discussion>

As is clear from Table 1 above, it is shown that according to the polishing method of the present invention, even when a polishing pad, which usually does not lead to an increase in polishing speed, is used, the polishing speed can be increased. In addition, because a polishing pad is used, leveling (start-up operation) and facing are unnecessary. Accordingly, the overall operating efficiency also increases, which contributes to the improvement of the silicon carbide substrate polishing efficiency.

In contrast, according to Comparative Examples 1, 2, and 4 where a platen (cast iron) was used in the primary polishing step, although the polishing performance is high, leveling (start-up operation) and facing are necessary. Thus, the overall operating efficiency does not increase, and the silicon carbide substrate polishing efficiency does not increase either. Meanwhile, in Comparative Example 3, the primary polishing step is polishing using a pad, and thus leveling (start-up operation) and facing are unnecessary. However, the polishing performance is significantly low, and, from the overall standpoint, the silicon carbide substrate polishing efficiency does not increase.

Points to pay to attention about the present invention are as follows.

Point (i): The Vickers hardness of SiC is 2,150 Hv, and the Vickers hardness of B₄C is 2,250 Hv. Therefore, the hardness of abrasive grains and the hardness of the object to be polished are on the same level. Further, because not a metal platen but a polyurethane polishing pad is used, usually, the polishing performance hardly increases. Actually, when a polishing is performed with abrasive grains having the same hardness as that of the object to be polished, the polishing performance hardly increases (Comparative Example 3). In contrast, according to the method of the present invention, high polishing performance is exerted (Example 1).

Point (ii): A common silicon carbide polishing process includes a rough lapping step, a diamond lapping step (platen, abrasive grains: diamond), and a CMP step (polishing pad, abrasive grains: colloidal silica). However, according to the present invention, an alternative means for the diamond lapping (platen, abrasive grains: diamond) step which uses particularly high-cost diamond, or a better means, is expected to be provided.

Incidentally, this application is based on Japanese Patent Application No. 2017-30216 filed on February 21, 2017, the contents of which are entirely incorporated herein by reference.

## Claims

1. A polishing method for polishing a silicon carbide substrate,
the polishing method comprising a primary polishing step of polishing with a polishing member A containing abrasive grains using a polishing pad,
wherein the primary polishing step is a polishing performed in association with a solid-phase reaction between the abrasive grains and the silicon carbide substrate.

2. The polishing method according to claim 1, wherein a maximum diffraction peak intensity observed at a diffraction angle 2θ in a range of 20 to 40° when a calcined product obtained by heating the abrasive grains alone or silicon carbide alone from 25°C to 1500°C is subjected to X-ray diffraction, decreases to equal to or less than a composite peak intensity of a calcined product of the abrasive grains alone and a calcined product of the silicon carbide alone at a diffraction angle 2θ of the maximum diffraction peak intensity when a calcined product obtained by heating a mixture of the silicon carbide and the abrasive grains at a weight ratio of 1:1 from 25°C to 1500°C is subjected to X-ray diffraction.

3. The polishing method according to claim 1, wherein a maximum diffraction peak intensity observed at a diffraction angle 2θ in a range of 20 to 40° when a calcined product obtained by heating the abrasive grains alone or silicon carbide alone from 25°C to 1000°C is subjected to X-ray diffraction, decreases to equal to or less than a composite peak intensity of a calcined product of the abrasive grains alone and a calcined product of the silicon carbide alone at a diffraction angle 2θ of the maximum diffraction peak intensity when a calcined product obtained by heating a mixture of the silicon carbide and the abrasive grains at a weight ratio of 1:1 from 25°C to 1000°C is subjected to X-ray diffraction.

4. The polishing method according to any one of claims 1 to 3, wherein the polishing member A is a polishing slurry containing abrasive grains.

5. The polishing method according to any one of claims 1 to 4, wherein a Vickers hardness of the abrasive grains is 2,000 to 4,000 Hv.

6. The polishing method according to any one of claims 1 to 5, wherein the abrasive grains are B₄C or TiB₂.

7. The polishing method according to any one of claims 1 to 6, wherein an average secondary particle size of the abrasive grains is 5 to 50 µm.

8. Abrasive grains for use in a primary polishing step of polishing using a polishing pad in a polishing method for polishing a silicon carbide substrate,
wherein the abrasive grains have a function of polishing in association with a solid-phase reaction with the silicon carbide substrate.

9. Abrasive grains for use in a primary polishing step of polishing using a polishing pad in a polishing method for polishing a silicon carbide substrate,
wherein the abrasive grains are ones such that a maximum diffraction peak intensity observed at a diffraction angle 2θ in a range of 20 to 40° when a calcined product obtained by heating the abrasive grains alone or silicon carbide alone from 25°C to 1500°C is subjected to X-ray diffraction, decreases to equal to or less than a composite peak intensity of a calcined product of the abrasive grains alone and a calcined product of the silicon carbide alone at a diffraction angle 2θ of the maximum diffraction peak intensity when a calcined product obtained by heating a mixture of the silicon carbide and the abrasive grains at a weight ratio of 1:1 from 25°C to 1500°C is subjected to X-ray diffraction.

10. Abrasive grains for use in a primary polishing step of polishing using a polishing pad in a polishing method for polishing a silicon carbide substrate,
wherein the abrasive grains are ones such that a maximum diffraction peak intensity observed at a diffraction angle 2θ in a range of 20 to 40° when a calcined product obtained by heating the abrasive grains alone or silicon carbide alone from 25°C to 1000°C is subjected to X-ray diffraction, decreases to equal to or less than a composite peak intensity of a calcined product of the abrasive grains alone and a calcined product of the silicon carbide alone at a diffraction angle 2θ of the maximum diffraction peak intensity when a calcined product obtained by heating a mixture of the silicon carbide and the abrasive grains at a weight ratio of 1:1 from 25°C to 1000°C is subjected to X-ray diffraction.

11. A method for producing a polished silicon carbide substrate, comprising a step of polishing by a polishing method according to any one of claims 1 to 7 or a primary polishing step of polishing a silicon carbide substrate using abrasive grains according to any one of claims 8 to 10 using a polishing pad.
